Europäisches Patentamt

European Patent Office

Office européen des brevets

(11) Veröffentlichungsnummer: **0 487 802 A1**

# EUROPÄISCHE PATENTANMELDUNG

(21) Anmeldenummer: **90402830.5**

(51) Int. Cl.5: **H04Q 1/14**

(22) Anmeldetag: **10.10.90**

(43) Veröffentlichungstag der Anmeldung:
**03.06.92 Patentblatt 92/23**

(84) Benannte Vertragsstaaten:
**AT BE CH DE ES FR GB IT LI NL SE**

(71) Anmelder: **ALCATEL N.V.**
**Strawinskylaan 341 (World Trade Center)**
**NL-1077 XX Amsterdam(NL)**
(84) **BE CH ES GB IT LI NL SE AT**

(71) Anmelder: **Standard Elektrik Lorenz**
**Aktiengesellschaft**
**Lorenzstrasse 10**
**W-7000 Stuttgart 40(DE)**
(84) **DE**

(71) Anmelder: **ALCATEL CIT**

**12 Rue de la Baume**
**F-75008 Paris(FR)**
(84) **FR**

(72) Erfinder: **Steffen, Günter**
**Schlossgartenstrasse 12**
**W-7254 Hemmingen(DE)**
Erfinder: **Roger, Jacques**
**Rue Saint Pol Roux 13**
**F-78280 Guyancourt(FR)**

(74) Vertreter: **Gähr, Hans-Dieter, Dipl.-Ing. (FH) et al**
**Standard Elektrik Lorenz AG Patent- und**
**Lizenzwesen Postfach 30 09 29**
**W-7000 Stuttgart 30(DE)**

(54) **Verteiler für die Nachrichtentechnik.**

(57) Der Verteiler (1) ist für den Anschluß externer und interner Kabel (7, 8) für abgeschirmte Schränke (S) der Nachrichtentechnik vorgesehen. Er besteht aus einem schrankartigen Gehäuse (2) mit Tür (3), das im Schrank (S) befestigt ist, sowie aus Schienen (4a) als Träger für Steckverbinder (KS, GS, KL) und blinden Schienen (4b). Die Schienen (4a, 4b) haben U-Profil und sind einhäng- und verriegelbar an der Rückwand (5) im Gehäuse (2) angeordnet. Sie bilden zusammen mit Rückwand (5) und Bodenplatte (14) des Gehäuses (2) eine Abschirmwand, an die von vorn (außen) die externen Leitungen (7) an die Steckverbinder (GS, KS, KL) gesteckt werden, an die von hinten (innen) die internen Leitungen (8) geführt sind.

FIG.1

Die Erfindung betrifft einen Verteiler der Nachrichtentechnik nach dem Oberbegriff des Anspruchs 1.

In der DE-OS 21 47 336 ist ein Verteiler für Fernmeldeanlagen beschrieben, bei dem an einem Gestell in regelmäßiger Anordnung Verbindungselemente angebracht sind, zu denen die ankommenden und abgehenden Leitungen oder Kabel geführt sind. Das Gestell wird von Gestellholmen gebildet, die in üblicher Weise senkrecht und waagerecht verlaufen und auf dem Boden des Aufstellungsraumes ruhen. Die Verbindungselemente sind Trenn- oder Schalt- oder einfache Durchgangsverteilerbausteine, die offen neben- und übereinander angeordnet sind. Dazwischen verbleiben Schneisen für die Leitungsführung.

Oft werden die Gestelle der Nachrichtentechnik durch Blechverkleidungen zu Schränken ergänzt. Solche Schränke oder Schrankgestelle sind beispielsweise in der DE 29 11 444 A1 beschrieben, wobei es sich sowohl um Einzelschränke als auch um anreihbare Schränke handeln kann. Vorderseitig sind die Schränke in der Regel mit Türen ausgerüstet, rückseitig nur bei Bedarf und in Abhängigkeit von der Aufstellung, ob freistehend oder an der Wand.

Im letzteren Fall werden, wie auch an den Seiten, feststehende Verkleidungsbleche angebracht. Hatten die Verkleidungen neben ihrer ästhetischen Wirkung zunächst nur schützende Funktion in mechanischer Hinsicht, so kommt ihnen seit dem Vordringen der digitalen Technik auch immer größere Bedeutung als Abschirmung gegen elektromagnetische Störstrahlung zu.

Besonders wichtig bei den Abschirmungsmaßnahmen sind Kabel- und Leitungseinführungen, z.B. am Verteiler, um dort elektromagnetisch dichte Durchgänge durch die Abschirmung sicherzustellen.

Der Erfindung liegt deshalb die Aufgabe zugrunde, einen Verteiler für die Nachrichtentechnik zu schaffen, der gegen Störstrahlung sicher abgeschirmt, für die Unterbringung unterschiedlicher Leitungen und Steckverbinder geeignet und einfach herzustellen ist. Gelöst wird diese Aufgabe durch die im Anspruch 1 angegebenen Merkmale. Vorteilhafte Weiterbildungen sind den Unteransprüchen zu entnehmen.

Die Erfindung wird an einem Ausführungsbeispiel beschrieben, das in den zugehörigen Zeichnungen dargestellt ist. Darin zeigen:

Fig. 1 einen Ausschnitt aus einem Schrank der Nachrichtentechnik mit einem eingesetzten, abgeschirmten Verteiler, dessen Gehäuse bei geöffneter Tür Einblick auf Schienen, z.T. mit Steckverbindern zum Anschluß von externen Leitungen gewährt, in perspektivischer Darstellung,

Fig. 2 einen Teil einer Schiene aus dem Verteiler nach Fig. 1 mit Öffnungen zum Einsatz von und teilweise mit unterschiedlichen Steckverbindern, in perspektivischer Ansicht.

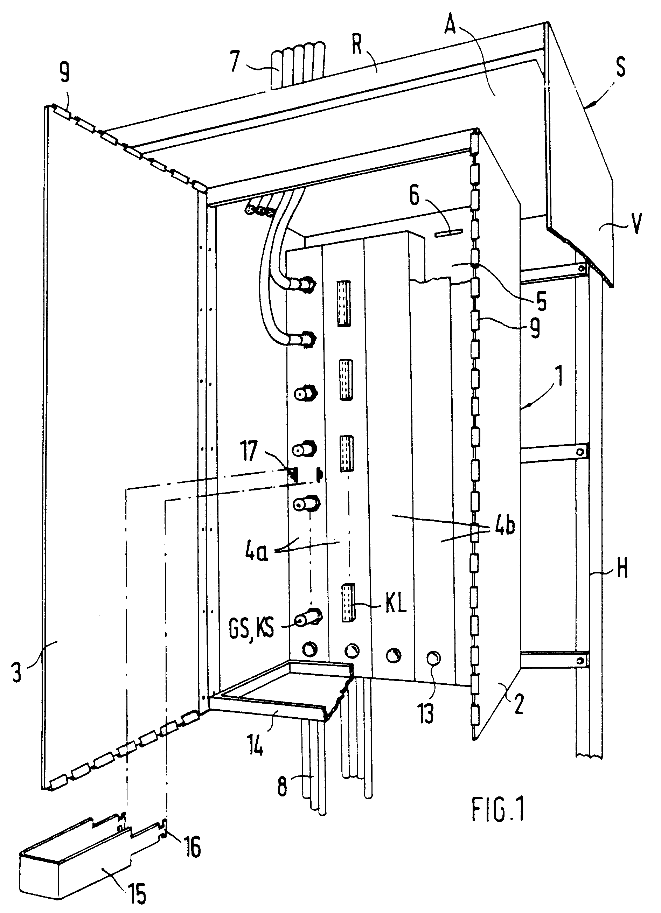

Der in Fig. 1 dargestellte Verteiler 1 ist in einen EMV-gerecht abgeschirmten Schrank S der Nachrichtentechnik eingebaut. Von diesem Schrank ist nur ein Ausschnitt mit Teilen gezeigt, die dem Verteiler 1 benachbart sind, wie z.B. der obere Rahmen R, ein Teil eines vertikalen Holmes H sowie ein Teil der Schrankverkleidung V. Der obere Rahmen R ist bis an das Gehäuse 2 des Verteilers 1 heran durch Abdeckbleche A verschlossen.

Der Verteiler 1 besteht aus einem schrankartigen Gehäuse 2 mit einer frontseitigen Tür 3 und darin untergebrachten Schienen 4a, die als Träger von Steckverbindern und ggf. auch Schalteinrichtungen (nicht dargestellt) dienen. Außerdem sind auch blinde Schienen 4b vorhanden, deren Funktion noch erläutert wird. Das Gehäuse 2 ist oben offen und unten durch eine entfernbare Bodenplatte 14 geschlossen. Letztere kann als Schieber ausgebildet sein und bei geöffneter Tür 3 von vorn einsteckbar bzw. nach vorn ausziehbar sein. Gehäuse 2, Tür 3 und Bodenplatte 14 sind zweckmäßig aus nichtrostendem Stahl gefertigt.

Die Trennfugen zwischen Gehäuse 2, Tür 3 und Bodenplatte 14 sind mit Hilfe von handelsüblichen Kontaktfedern g (z.B. nach der PCT 85/00378) oder Kontaktfederstreifen elektrisch abgedichtet.

Die Kabel oder Leitungen sind von oben und unten in das Gehäuse 2 des Verteilers 1 geführt, beispielsweise die externen Leitungen 7 von oben durch die Gehäuseöffnung und die internen Leitungen 8 (Gestellverbindung) von unten in die Schienen 4a.

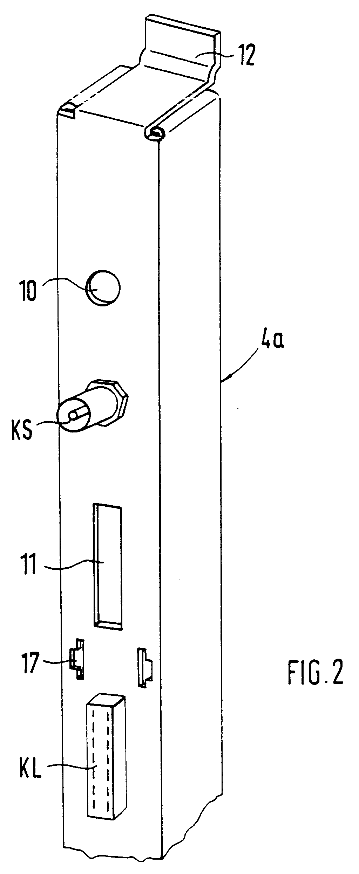

Die Schienen 4a bzw. 4b haben U-Profil und sind ebenfalls zweckmäßig aus nichtrostendem Stahl hergestellt. Die Schienen sind vertikal unmittelbar nebeneinander an der Rückwand 5 des Gehäuses 2 angeordnet. Während jeweils die untere Stirnseite der Schienen 4a und 4b offen ist, ist die obere Stirnseite geschlossen und mit einem Lappen 12 versehen, der über die Ebene, in der die freien Schenkel des Profils enden, noch hinaussteht und parallel zu dieser Ebene nach außen ragt, was aus Fig. 2 ersichtlich ist.

In der Rückwand 5 des Gehäuses 2 sind im oberen Bereich quer verlaufende Schlitze 6 (Fig. 1), in die die Lappen 12 der Schienen 4a, 4b einsteckbar sind. Der Abstand der Schlitze 6 ist so bemessen, daß Schiene an Schiene zu stehen kommt. Nahe dem unteren Ende ist jede Schiene 4a oder 4b mit einem handelsüblichen Druckriegel 13 ausgestattet, der durch Eindrücken die Schiene an der Rückwand 5 festlegt. Da beim Einsetzen der Schienen 4a ihre offene Profilseite der Rückwand 5 zugewandt ist, entsteht jeweils ein Kanal, in dem die internen Leitungen 8 zu den Steckverbindern KL oder KS geführt werden können.

Neben den mit Steckverbindern bestückbaren Schienen 4a werden für den Minderausbau außerdem blinde Schienen 4b ohne Bestückmöglichkeit benötigt (Fig. 1). Mit ihnen werden die nicht mit Steckverbindern belegten Schienenplätze im Verteiler 1 aufgefüllt.

Für die Montage der Steckverbinder, wie Glasfaserstecker oder -steckbuchsen GS, Koaxialstekker oder -steckbuchsen KS, Steckkontaktleisten KL und dgl., sind die Schienen 4a mit entsprechenden Öffnungen versehen. In Fig. 2 ist ein Teil einer Schiene 4a für gemischte Bestückung gezeigt, in der runde Öffnungen 10 für Glasfasersteckverbinder GS oder Koaxialsteckverbinder KS und rechteckige Öffnungen 11 für Steckkontaktleisten KL angebracht sind. Dagegen sind in Fig. 1 Schienen 4a für ausschließlich Glasfasersteckverbinder GS oder Koaxialsteckverbinder KS sowie Schienen für nur Steckkontaktleisten KL dargestellt. Die Schienen 4a werden vor dem Einbau im Verteiler 1 mit Steckverbindern GS, KL, KS, Leitungen 8 und Schalteinrichtungen bestückt, so daß sie fertig verkabelt mit wenigen Handgriffen einsetzbar sind.

Nach Einsetzen aller Schienen 4a und 4b in den Verteiler 1 wird die Bodenplatte 14 eingeschoben, durch die die verbleibende Bodenöffnung des Gehäuses 2 zwischen Schienen 4a bzw. 4b und Tür 3 geschlossen wird. Damit ist eine durchgehende Abschirmung zwischen externem und internem Bereich geschaffen. Der Bereich, in dem die externen Leitungen 7 an den Steckverbindern KL, KS, GS angesteckt enden, ist demnach ein oben offener Schacht, der von der Tür 3, den Seitenwänden des Gehäuses 2, den Schienen 4a und 4b und der Bodenplatte 14 begrenzt wird, während der Bereich, in dem die internen Leitungen 8 liegen, in mehrere, unten offene Schächte gegliedert ist, die jeweils von den Schienen 4a und der Rückwand 5 gebildet werden. Durch diese modulare Bauweise wird eine flexible Verteilung der Leitungen in einem gegen Störstrahlungen unempfindlichen Raum ermöglicht.

Zur Ordnung der externen Leitungen 7 können bei Bedarf an den Schienen 4a Kabelhalter 15 angebracht werden. Die Kabelhalter sind U-förmige Bügel aus Blech oder Kunststoff, deren freie Enden jeweils einen T-förmigen Ansatz 16 haben. Die Schienen 4a sind mit mindestens einem Paar T-förmiger, auseinander gerichteter Schlitze 17 versehen, die nahe der vorderen Kante der Schiene angeordnet sind. Beim dargestellten Beispiel in Fig. 1 liegen die Schlitze 17 ungefähr in der Mitte der Schiene. Sie können auch weiter oben angebracht sein, wo das Bündel der zugeführten Leitungen noch am dicksten ist. Sind mehrere Paare Schlitze 17 über die Länge der Schiene verteilt, so kann ein Kabelhalter 15, bei Bedarf auch zwei an geeigneten Stellen eingesetzt werden. Das Einsetzen geschieht einfach durch geringfügiges Zusammendrücken der über die Leitungen 7 geschobenen freien Schenkel des Kabelhalters 15, bis die Ansätze 16 in die vertikalen Teile der Schlitze 17 passen und bis zum Anschlag eingeschoben werden können. Beim Loslassen federn die freien Schenkel wieder auseinander, wobei die hinterschnittenen Teile der T-förmigen Ansätze 16 in die horizontalen Teile der T-förmigen Schlitze 17 gleiten. Durch diese Einrenkverbindung ist der Kabelhalter 15 an der Schiene 4a fixiert. Durch die Kabelhalter 15 können die externen Leitungen 7 zu übersichtlichen Bündeln geordnet werden.

Die Tür 3 kann, wie die Schienen, mit wenigstens einem Druckriegel versehen sein, der durch Eindrücken die Tür im geschlossenen Zustand am Gehäuse festlegt (nicht dargestellt). Andere Möglichkeiten, die Tür zu verriegeln, sind beispielsweise Drehriegel, Schlösser, Magnetverschlüsse usw.

## Patentansprüche

1. Verteiler mit Verbinder-Bauelementen für den elektrischen Anschluß von externen und internen Leitungen, für Schränke der elektrischen Nachrichtentechnik,
   **dadurch gekennzeichnet,** daß der Verteiler (1) ein schrankartiges, oben offenes, in einem EMV-gerecht abgeschirmten Schrank (S) montiertes Gehäuse (2) mit frontseitiger Tür (3) hat, in dem an der Rückwand (5) Schienen (4a, 4b) vertikal nebeneinander angebracht sind, die ein zur Rückwand (5) offenes Profil haben, deren obere Stirnseite geschlossen und deren untere Stirnseite offen ist, daß die vor den Schienen (4a, 4b) verbleibende Bodenöffnung des Gehäuses (2) durch eine Bodenplatte (14) verschlossen wird, daß die Schienen (4a) nach Bedarf mit Steckverbindern (GS, KL, KS) und gegebenenfalls Schalteinrichtungen bestückt und die festangeschlossenen, internen Leitungen (8) in den Schienen (4a) nach unten durch ihre offene Stirnseite aus dem Gehäuse (2) und die an die Steckverbinder (GS, KL, KS) ansteckbaren, externen Leitungen (7) von oben in das Gehäuse (2) geführt sind.

2. Verteiler nach Anspruch 1, dadurch gekennzeichnet, daß die Schienen (4a, 4b) U-Profil haben.

3. Verteiler nach Anspruch 2, dadurch gekennzeichnet, daß die Schienen (4a, 4b) jeweils am oberen Ende einen abgewinkelten Lappen (12) haben, mit dem sie in einen Schlitz (6) in der Rückwand (5) des Gehäuses (2) einhängbar sind.

4. Verteiler nach Anspruch 3, dadurch gekennzeichnet, daß die Schienen (4a, 4b) jeweils am unteren Ende mit einem Druckriegel (13) ausgerüstet sind, der an der Rückwand (5) des Gehäuses (2) einrastbar ist.

5. Verteiler nach Anspruch 4, dadurch gekennzeichnet, daß die Schienen wahlweise ohne (4b) oder mit (4a) Öffnungen (10, 11) zur Aufnahme von Steckverbindern (GS, KS, KL) sind.

6. Verteiler nach Anspruch 5, dadurch gekennzeichnet, daß die Schienen (4a) mit mindestens einem Paar T-förmiger Schlitze (17) versehen sind, in die ein U-förmiger Kabelhalter (15) mittels T-förmiger Ansätze (16) an seinen freien Enden federnd einrenkbar ist.

7. Verteiler nach Anspruch 1, dadurch gekennzeichnet, daß die Bodenplatte (14) als herausnehmbarer Schieber ausgebildet ist.

8. Verteiler nach Anspruch 1, dadurch gekennzeichnet, daß die Trennfuge zwischen Tür (3), Gehäuse (2) und Bodenplatte (14) mittels Kontaktfedern (9) elektromagnetisch dicht ist.

FIG.1

12

10

4a

KS

11

17

FIG.2

KL

Europäisches
Patentamt

**EUROPÄISCHER RECHERCHENBERICHT**

Nummer der Anmeldung

EP    90 40 2830

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| Y | NACHRICHTEN ELEKTRONIK UND TELEMATIK. vol. 40, no. 12, Dezember 1986, HEIDELBERG DE Seiten 523 - 527; VON RUEDIGER WOLPERS: "Verteiler in Kommunikationsnetzen" * das ganze Dokument * --- | 1, 8 | H04Q1/14 |
| Y | US-A-4679867 (HELDENBRAND ET AL.) * Spalte 3, Zeilen 7 - 64 * --- | 1, 8 | |
| A | PHILIPS TELECOMMUNICATION REVIEW. vol. 43, no. 1, April 1985, HILVERSUM NL Seiten 12 - 16; K. BROKKELKAMP: "Electro-magnetic compatibility in design 400-slim" * das ganze Dokument * --- | 1 | |
| A | US-A-4605275 (PAVEL) * Anspruch 1 * --- | 1 | |
| A,D | DE-A-2147336 (SIEMENS AG) * Figur 2 * --- | 1 | RECHERCHIERTE SACHGEBIETE (Int. Cl.5 ) |
| A,D | FR-A-2452230 (INTERNATIONAL STANDARD ELECTRIC CORPORATION) ----- | ✎ | H04Q H05K |

Der vorliegende Recherchenbericht wurde für alle Patentansprüche erstellt

| Recherchenort | Abschlußdatum der Recherche | Prüfer |
|---|---|---|
| DEN HAAG | 13 JUNI 1991 | TOUSSAINT F.M.A. |